# EUROPÄISCHE PATENTSCHRIFT

(11) **EP 0 921 717 B1**
(45) Veröffentlichungstag und Bekanntmachung des Hinweises auf die Patenterteilung: **14.04.2004**
(21) Anmeldenummer: 98811126.6
(22) Anmeldetag: 11.11.1998
(51) Int. Cl.: H05K 7/20, H02M 7/00

(54) **Kühlsystem für eine elektrotechnische Anlage, insbesondere für einen Stromrichter insbesondere einer elektrischen Lokomotive oder eines Triebwagens**
Cooling system for an electrotechnical installation , particularly for converter of locomotive or railcar
Système de refroidissement pour une installation électrotechnique, notamment pour convertisseur de locomotive ou d' autorail

(30) Priorität: 08.12.1997 DE 19754284
(43) Veröffentlichungstag der Anmeldung: 09.06.1999
(73) Patentinhaber: DaimlerChrysler Rail Systems GmbH, 13627 Berlin (DE)
(72) Erfinder: Meyer, Urs, 5400 Baden (CH); Tute, Axel, 79790 Küssaberg, Dangstetten (DE)
(74) Vertreter: COHAUSZ & FLORACK

(56) Entgegenhaltungen:
- EP-A- 0 446 836
- EP-A- 0 767 601
- HEINEMEYER P ET AL: "HOCHLEISTUNGS-STROMRICHTER MIT UMWELTFREUNDLICHER KUEHLTECHNIK" ZEITSCHRIFT FUR EISENBAHNWESEN UND VERKEHRSTECHNIK. DIE EISENBAHN TECHNIK + GLASERS ANNALEN, Bd. 116, Nr. 8 / 09, 1. August 1992 (1992-08-01), Seiten 319-326, XP000312090 ISSN: 0941-0589
- BOCCHETTI G ET AL: "3 MW CONVERTER FOR HIGH POWER UNIVERSAL LOCOMOTIVE BASED ON A DEIONIZED WATER COOLED GTO MODULE: IMPROVEMENTS AND TYPE TESTS" DRIVES 1, BRIGHTON, SEPT. 13 - 16, 1993, Bd. 5, Nr. CONF. 5, 13. September 1993 (1993-09-13), Seiten 241-246, XP000416902 INSTITUTION OF ELECTRICAL ENGINEERS
- FUHRER W M ET AL: "WATER-COOLED HIGH POWER GTO CONVERTERS FOR ELECTRIC TRACTION" DRIVES 1, BRIGHTON, SEPT. 13 - 16, 1993, Bd. 5, Nr. CONF. 5, 13. September 1993 (1993-09-13), Seiten 294-298, XP000416909 INSTITUTION OF ELECTRICAL ENGINEERS

## Beschreibung

### Technisches Gebiet

Die Erfindung bezieht sich auf das Gebiet des Kühltechnik. Sie geht aus von einem Kühlsystem für eine elektrotechnische Anlage, insbesondere für einen Stromrichter vorzugsweise einer elektrischen Lokomotive oder eines Triebwagens, gemäss dem Oberbegriff des ersten Anspruchs.

### Stand der Technik

Ein gattungsgemässes Kühlsystem wird Artikel "Hochleistungs-Stromrichter mit umweltfreundlicher Kühltechnik", ZEV-DET Glas. Ann. 116 (1192) Nr. 8/9 August/September von Peter Heinemeyer et al. beschrieben. Elektrotechnische Anlagen hoher Leistung, zu denen auch Stromrichter gehören, benötigen ein Kühlsystem zur Abfuhr der in den Elementen, insbesondere den Halbleiterbauelementen und deren Beschaltung, entstehenden Verlustwärme. Zu diesem Zweck ist ein Kühlkreislauf vorgesehen, in welchen zur Zirkulation des Kühlmittels eine Pumpe und zur Abkühlung des Kühlmittels eine Rückkühlvorrichtung eingeschaltet sind. Ausserdem ist ein Ausgleichsgefäss an den Kreislauf angeschlossen, das Raum für temperaturabhängige Volumenänderungen des Kühlmittels zur Verfügung stellt und zudem als Reservoir dient. Die zu kühlenden Elemente wie Leistungshalbleiterbauelemente und ihre Beschaltungen (z.B. Drosseln und Widerstände) sind entweder in Reihe oder parallel an den Kühlkreislauf angeschlossen. Beim erwähnten Kühlsystem sind die Elemente mit beidseitig schliessenden Schnellverschlusskupplungen ausgerüstet, damit der Kühlkreislauf beim Austausch eines flüssigkeitsgekühlten Elements oder anderen Wartungsarbeiten ohne Ablassen des Kühlmittels geöffnet werden kann. Ein Kühlsystem, das Schnellverschlusskupplungen verwendet, ist ausserdem aus dem Artikel "3 MW Converter for High Power Universal Locomotive Based on a Deionized Water Cooled GTO Module: Improvements and Type Test", vorgestellt an der EPE in Brighton (13. - 16.9.1993), bekannt. Eine vergleichbare Lösung wird im Artikel "Water-Cooled High Power GTO Converters for Electric Traction", vorgestellt an der EPE in Brighton (13. - 16.9.1993), beschrieben.

Schnellverschlusskupplungen sind zwar in Hinblick auf einfache Wartungsmöglichkeiten sehr angenehm. Sie sind jedoch sehr teuer, umfassen eine Vielzahl von Dichtstellen, benötigen viel Platz und stellen Probleme bezüglich der Einbautoleranzen. Ausserdem müssen die Kupplungen äusserst sicher sein. Ein Ablassen des Kühlmittels für Wartungszwecke ist aber ebensowenig erwünscht, da dadurch ebenfalls unerwünschte Kosten entstehen.

Die EP 0 767 601 A1 betrifft demgegenüber ein gattungsgemäßes Kühlsystem ohne Schnellverschlusskupplungen, bei dem zwischen einem am tiefsten Punkt des geschlossenen Kreislaufs gelegenen Reservoir und dem höchsten Punkt des Wärmetauschers eine stets geöffnete Entlüftungsleitung vorgesehen ist, die dafür sorgt, dass das Kühlmittel bei Abschalten der Pumpe sofort in das Reservoir abläuft. Über die Entlüftungsleitung gelangt die oberhalb des Kühlmittelspiegels befindliche Luft aus dem Reservoir an den höchsten Punkt des Kreislaufs, sodass der Kühlkreislauf in das Reservoir hinein leer laufen kann. Eine Reparatur ist daher möglich, ohne dass das Kühlmittel aus dem Kühlsystem abgelassen werden muss.

Dieses Kühlsystem benötigt zwar keine Schnellverschlusskupplungen, es weist jedoch zum einen den Nachteil auf, dass mit der Entlüftungsleitung ein vergleichsweise langes und damit aufwändiges, entsprechend groß dimensioniertes Bauteil erforderlich ist, um die gewünschte Funktion des Entleerens des Kühlkreislaufs in das Reservoir sicherzustellen. Ein weiterer Nachteil dieses Kühlsystems liegt darin, dass die Pumpe stets laufen muss, um den Kühlkreislauf gefüllt zu halten. Hierdurch vergeht im Normalbetrieb bei jedem Anlaufen der Pumpe eine vergleichsweise lange Zeit, bis das Kühlsystem seine volle Kühlleistung erbringen kann.

### Darstellung der Erfindung

Aufgabe der Erfindung ist es deshalb, ein Kühlsystem für eine elektrotechnische Anlage anzugeben, das sehr wartungsfreundlich ist, ohne Schnellverschlusskupplungen auskommt und kostengünstig aufgebaut werden kann. Diese Aufgabe wird durch die Merkmale des unabhängigen Anspruchs 1 gelöst.

Kern der Erfindung ist es also, dass das Ausgleichsgefäss an der tiefsten Stelle des Kühlsystems angeordnet ist und dass das Ausgleichsgefäss genügenden freies Volumen aufweist, um das Volumen des oberhalb des Ausgleichsgefässes liegenden Restkreislaufes aufzunehmen. Das Ausgleichsgefäß weist dabei erfindungsgemäß einen zum Entleeren des Kühlerkreislaufs zu öffnenden Kühlverschluss auf und ist zum Entgasen des im Kühlkreislauf enthaltenen Kühlmittels ausgebildet. Weitere vorteilhafte Ausführungsformen ergeben sich aus den entsprechenden abhängigen Ansprüchen.

Die Vorteile der Erfindung sind neben wesentlichen Kosteneinsparungen aufgrund der Nichtverwendung von Schnellverschlusskupplungen insbesondere in der sehr einfachen Wartungsmöglichkeit zu sehen.

### Kurze Beschreibung der Zeichnungen

Nachfolgend wird die Erfindung anhand von Ausführungsbeispielen im Zusammenhang mit den Zeichnungen näher erläutert.

Es zeigen:
- Fig.1: Ein erfindungsgemässes Kühlsystem von der Seite;
- Fig. 2: Ein erfindungsgemässes Kühlsystem von oben;
- **Fig. 3**: Eine erste Ausführungsform eines für die Erfindung geeigneten Ausgleichsgefässes;
- **Fig. 4**: Eine zweite Ausführungsform eines für die Erfindung geeigneten Ausgleichsgefässes.

Die in den Zeichnungen verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen.

### Wege zur Ausführung der Erfindung

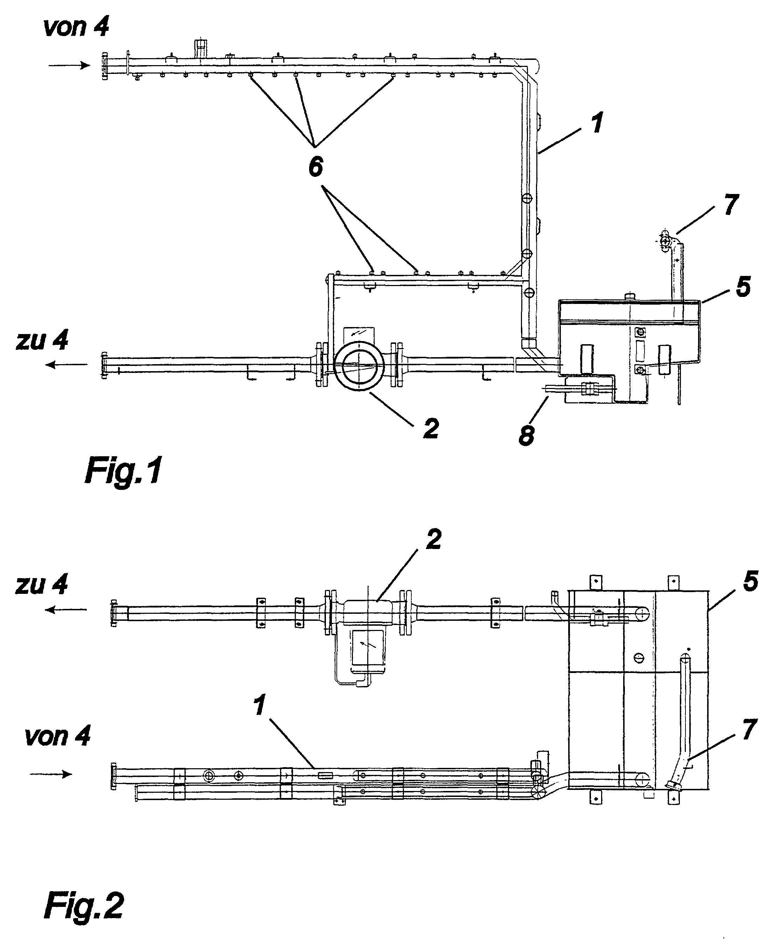

Figur 1 zeigt ein erfindungsgemässes Kühlsystem von der Seite, Figur 2 von oben. Das Kühlsystem ist insbesondere für die Kühlung der Elemente eines Antriebsstromrichters einer elektrischen Lokomotive geeignet. Es umfasst eine Kühlkreislauf 1, in welchem Kühlmittel 3 mit Hilfe einer leistungsfähigen Pumpe 2 in Zirkulation versetzt wird. Ausserdem ist eine nicht dargestellte Rückkühlvorrichtung 4 vorgesehen, in welche dem Kühlmittel 3 Wärme, die es von den zu kühlenden Elementen aufgenommen hat, wieder entzogen wird. Die Rückkühlvorrichtung kann insbesondere einen Kühlturm oder einen Wasser-Luft-Wärmetauscher, bei dem eine forcierte Luftströmung mittels eines Lüfters erzeugt wird, umfassen. Ausserdem ist ein Ausgleichsgefäss 5 vorgesehen, das den Raum für temperaturabhängige Volumenänderungen des Kühlmittels und eine Reserve für geringe Kühlmittelverluste zur Verfügung stellt. Die zu kühlenden Elemente wie Leistungshalbleiterschalter, Dioden, Widerstände usw. sind über Anschlüsse 6 mit dem Kühlkreislauf 1 verbunden. Die Elemente werden vorzugsweise mit Hilfe von Kühlmittel durchströmten Kühlkörpern gekühlt. Um eine einfache Wartung des Kühlsystems zu erlauben, ohne dass die Anschlüsse 6 für die Elemente mit teueren Schnellverschlusskupplungen ausgerüstet sein müssen, ist das Ausgleichsgefäss 5 erfindungsgemäss an der tiefsten Stelle des Kühlsystems angeordnet. Ausserdem weist das Ausgleichsgefäss im Betrieb genügenden freies Volumen auf, um bei einer Wartung das Volumen des im Kühlsystem oberhalb des Ausgleichsgefäss befindlichen Teils des Kühlmittels aufnehmen zu können. Durch Öffnen des Kühlerverschlusses 7 und einer Verschraubung eines Elements läuft der Kühlkreislauf leer, und die Kühlflüssigkeit sammelt sich somit im Ausgleichgefäss. Nach erfolgter Wartung, z.B. dem Austausch eines defekten Elements, saugt die Pumpe 2 das Kühlmittel 3 aus dem Ausgleichsgefäss 5 an und drückt es in den Kühlkreislauf 1. Im Ausgleichsgefäss muss deshalb eine Entgasung vorgesehen, die die im Kühlkreislauf enthaltene Luft entfernt.

Erfindungsgemäss werden somit folgende Anforderungen an das Ausgleichsgefäss gestellt:
- Aufnahme des im Kühlkreislauf befindlichen Kühlmittels bei der Wartung
- Aufnahme des Expansionsvolumens bei positiver und negativer Temperaturänderung
- Entlüftung des Kreislaufs nach erfolgter Wartung
- Kein Ansaugen von Luft bei voller Beschleunigung der Pumpe aus dem Ausgleichsgefäss
- Trennen von Luft und Kühlmittel im Ausgleichsgefäss, um das Eindiffundieren von Sauerstoff in das Kühlmittel zu erschweren

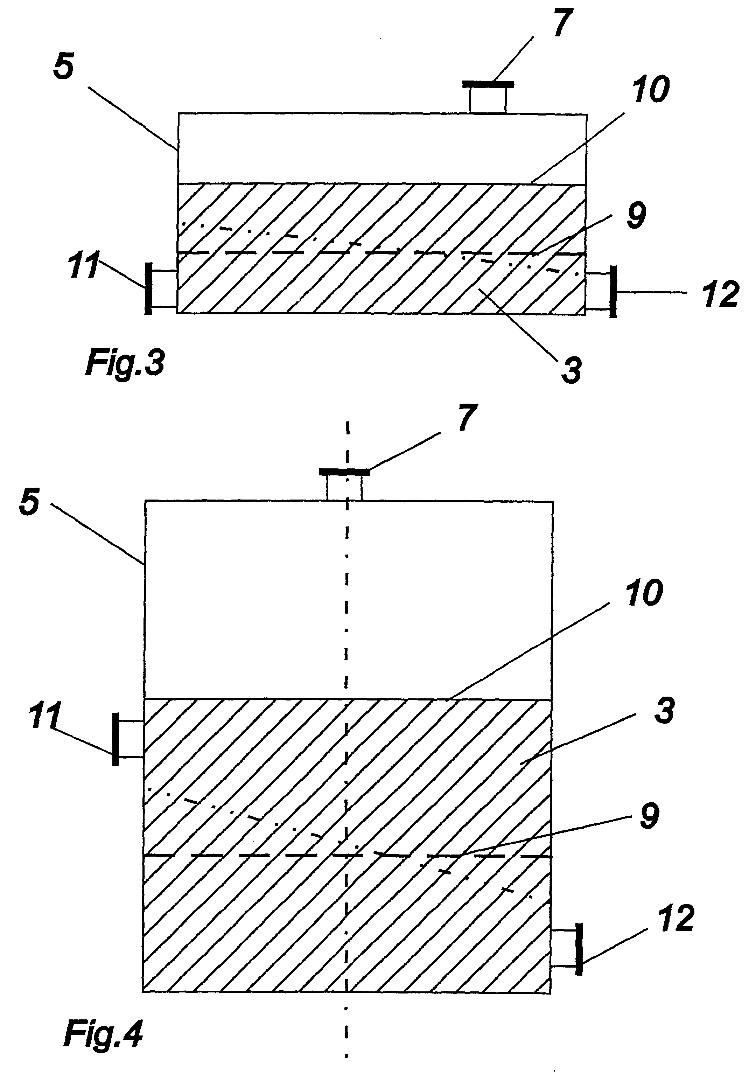

Diese Anforderungen können durch Ausgleichsgefässe, wie sie in den Figuren 3 und 4 dargestellt sind gelöst werden. Figur 3 zeigt ein Ausgleichsgefässe 5 mit einem Entlüftungskasten. Mit 9 ist eine Trennwand Kühlmittel-Luft bezeichnet, die ein Eindiffundieren von Sauerstoff in das Kühlmittel 3 erschwert. Mit 11 ist ein Kühlmitteleinlass und mit 12 ein Kühlmittelauslass bezeichnet. Beim Durchströmen des Ausgleichsgefässes kann die Luft nach oben steigen und gelangt damit nicht mehr in den Kreislauf. Das Ausgleichsgefäss muss ausserdem so dimensioniert sein, dass der Kühlmittelspiegel 10 im Ruhezustand bei maximaler Beschleunigung der Pumpe höchstens die strichpunktierte, schräge Linie erreicht. Sänke der Spiegel noch weiter ab, so würde die Pumpe aus dem Ausgleichsgefäss wieder unerwünschte Luft in Kühlkreislauf saugen.

Figur 4 zeigt ein Beispiel mit einem sog. "Dégasifier". Bei dieser Variante ist das Ausgleichsgefäss zylindrisch ausgeführt und Einlass 11 und Auslass 12 sind versetzt angeordnet. Durch diese Anordnung wird das Kühlmittel durch die Pumpe im Ausgleichsgefäss in eine Drehbewegung versetzt. Dadurch wird die Luft in die Mitte gedrückt und steigt in den oberen, durch eine Trennwand 9 abgetrennten Teil des Ausgleichsgefässes auf.

### Bezugszeichenliste

- 1: Kühlkreislauf
- 2: Kühlmittelpumpe
- 3: Kühlmittel
- 4: Rückkühlvorrichtung
- 5: Ausgleichsgefäss
- 6: Anschluss für zu kühlende Elemente
- 7: Kühlerverschluss
- 8: Füll- und Entleeranschluss
- 9: Trennwand Kühlmittel-Luft
- 10: Kühlmittelspiegel
- 11: Einlass
- 12: Auslass

## Patentansprüche

1. Kühlsystem für eine elektrotechnische Anlage, insbesondere für einen Stromrichter, vorzugsweise ein Antriebsstromrichter für die elektrische Traktionstechnik, umfassend
einen Kühlkreislauf (1), in welchen eine Kühlmittelpumpe (2) und eine Rückkühlvorrichtung (4) geschaltet sind, wobei die Kühlmittelpumpe (2) Kühlmittel (3) im Kühlkreislauf (1) in Umlauf setzt und die Rückkühlvorrichtung (4) dem Kühlmittel (3) aufgenommene Wärme entzieht,
ein Ausgleichsgefäß (5), das an den Kühlkreislauf (1) angeschlossen ist, und
eine Mehrzahl von zu kühlenden Elementen, die an Kühlkreislauf (1) angeschlossen sind, wobei
das Ausgleichsgefäß (5) an der tiefsten Stelle des Kühlsystems angeordnet ist und das Ausgleichsgefäß (5) im Betrieb des Kühlsystems mindestens ein so großes freies Volumen aufweist, dass es das Volumen des im Kühlsystem sich oberhalb des Ausgleichsgefäß (5) befindenden Teils des Kühlmittels (3) aufnehmen kann,
**dadurch gekennzeichnet, dass** das Ausgleichsgefäß zum Entgasen des im Kühlkreislauf (1) enthaltenen Kühlmittels (3) ausgebildet ist und einen zum Entleeren des Kühlkreislaufs (1) in das Ausgleichsgefäß (5) öffenbaren Kühlerverschluss (7) aufweist.

2. Kühlsystem nach Anspruch 1, **dadurch gekennzeichnet, dass** das Ausgleichsgefäß (5) Mittel zum Entgasen des im Kühlerkreislauf (1) enthaltenen Kühlmittels (3) aufweist.

3. Kühlsystem nach Anspruch 1 oder 2, **dadurch gekennzeichnet, dass** das Ausgleichsgefäß (5) nach Art eines Degasifiers ausgebildet ist.

4. Kühlsystem nach Anspruch 3, **dadurch gekennzeichnet, dass** das Ausgleichsgefäß (5) zylindrisch ausgeführt ist und zur Erzeugung einer Drehbewegung im Kühlmittel einen Einlass (11) und einen versetzt dazu angeordneten Auslass (12) aufweist.

5. Kühlsystem nach einem der vorhergehenden Ansprüche, **dadurch gekennzeichnet, dass** das Ausgleichsgefäß (5) zum Erschweren des Eindiffundierens von Sauerstoff in das Kühlmittel (3) eine Trennwand (9) aufweist.

6. Kühlsystem nach einem der vorhergehenden Ansprüche, **dadurch gekennzeichnet, dass** das Ausgleichsgefäß (5) zum Verhindern des Ansaugens von Luft in den Kühlkreislauf (1) derart ausgebildet ist, dass der Kühlmittelspiegel (10) bei maximaler Beschleunigung der Kühlmittelpumpe (2) nicht bis zum Auslass (12) absinkt.

## Claims

1. A cooling system for an electrotechnical installation, in particular for a power converter, preferably for a drive power converter for the electric traction technology, comprising
a cooling circuit (1) in which there are connected a coolant pump (2) and a recooling device (4), said coolant pump (2) circulating a coolant (3) within said cooling circuit (1) and said recooling device (4) drawing absorbed heat from said coolant (3),
an equalizing vessel (5) connected to said cooling circuit (1) and
a plurality of elements to be cooled that are connected to said cooling circuit (1),
said equalizing vessel (5) being disposed at the lowest point of said cooling system and said equalizing vessel (5) having a free volume that is, when said cooling circuit is in operation, at least as large to be capable of receiving the part of the volume of said coolant (3) located above said equalizing vessel (5) within said cooling system,
**characterized in that** said equalizing vessel is configured to degas said coolant (3) contained within said cooling circuit (1) and comprises an openable cooler closure means (7) for emptying said cooling circuit (1) into said equalizing vessel (5).

2. The cooling system according to claim 1, **characterized in that** said equalizing vessel (5) comprises means for degassing said coolant (3) contained within said cooling system (1).

3. The cooling system according to claim 1 or 2, **characterized in that** said equalizing vessel (5) is configured in the manner of a degasifier.

4. The cooling system according to claim 3, **characterized in that** said equalizing vessel (5) is configured to be cylindrical and comprises an inlet (11) and an outlet (12) that is offset relative thereto for producing a rotation within said coolant.

5. The cooling system according to one of the preceding claims, **characterized in that** said equalizing vessel (5) comprises a partition wall (9) for hampering diffusion of oxygen into said coolant (3).

6. The cooling system according to one of the preceding claims, **characterized in that**, for preventing air from being drawn into the cooling system (1), said equalizing vessel (5) is of such design as to prevent the coolant level (10) from dropping as far as said outlet (12) when said coolant pump (2) is undergoing maximum acceleration.

## Revendications

1. Système de refroidissement pour une installation électrotechnique, notamment pour un convertisseur, de préférence pour un convertisseur d'entraînement pour la technologie de la traction électrique, comprenant
un circuit de refroidissement (1) dans lequel sont agencés une pompe (2) pour le liquide de refroidissement et un dispositif de refroidissement de retour (4), la pompe (2) pour le liquide de refroidissement faisant circuler le liquide de refroidissement (3) dans le circuit de refroidissement (1) et le dispositif de refroidissement de retour (4) soutirant au liquide de refroidissement (3) la chaleur qu'il a absorbée,
un réservoir de compensation (5) raccordé au circuit de refroidissement (1), et
une pluralité d'éléments destinés à être refroidis et qui sont raccordés au circuit de refroidissement (1), le réservoir de compensation (5) étant disposé tout au fond du système de refroidissement et le réservoir de compensation (5) comportant un volume libre au moins suffisant, lorsque le système de refroidissement est en fonctionnement, pour pouvoir recevoir la fraction du volume de liquide de refroidissement (3) se situant au-dessus du réservoir de compensation (5) dans le système de refroidissement,
**caractérisé en ce que** le réservoir de compensation est conformé pour dégazer le liquide de refroidissement (3) contenu dans le circuit de refroidissement (1) et comporte une fermeture de radiateur (7) ouvrable pour vider le circuit de refroidissement (1) dans le réservoir de compensation (5).

2. Système de refroidissement selon la revendication 1, **caractérisé en ce que** le réservoir de compensation (5) comporte des moyens pour dégazer le liquide de refroidissement (3) contenu dans le circuit de refroidissement (1).

3. Système de refroidissement selon la revendication 1 ou 2, **caractérisé en ce que** le réservoir de compensation (5) est conformé sous forme de dégazeur.

4. Système de refroidissement selon la revendication 3, **caractérisé en ce que** le réservoir de compensation (5) est cylindrique et comporte, afin de générer un mouvement de rotation dans le liquide de refroidissement, une entrée (11) et, décalée par rapport à cette dernière, une sortie (12).

5. Système de refroidissement selon l'une quelconque des revendications précédentes, **caractérisé en ce que** le réservoir de compensation (5) comporte une cloison (9) destinée à compliquer la diffusion d'oxygène dans le liquide de refroidissement (3).

6. Système de refroidissement selon l'une quelconque des revendications précédentes, **caractérisé en ce que**, pour empêcher l'aspiration d'air dans le circuit de refroidissement (1), le réservoir de compensation (5) est conformé de telle sorte que le niveau (10) de liquide de refroidissement ne baisse pas jusqu'à la sortie (12) lorsque la pompe (2) pour le liquide de refroidissement subit une accélération maximale.
